# FASCICULE DE BREVET EUROPEEN

(11) **EP 4 163 684 B1**
(45) Date de publication et mention de la délivrance du brevet: **13.03.2024**
(21) Numéro de dépôt: 22195495.1
(22) Date de dépôt: 14.09.2022
(51) Int. Cl.: G02B 6/12, G02B 6/122, G02B 6/30

(54) **PUCE PHOTONIQUE**
PHOTONENCHIP
PHOTONIC CHIP

(30) Priorité: 05.10.2021 FR 2110550
(43) Date de publication de la demande: 12.04.2023
(73) Titulaire: Commissariat à l'énergie atomique et aux énergies alternatives, 75015 Paris (FR)
(72) Inventeur: RAMIREZ, Joan, 91767 Palaiseau CEDEX (FR); BITAULD, David, 91767 Palaiseau CEDEX (FR); HASSAN, Karim, 38054 GRENOBLE CEDEX 09 (FR); SZELAG, Bertrand, 38054 GRENOBLE CEDEX 09 (FR)
(74) Mandataire: INNOV-GROUP

(56) Documents cités:
- EP-A2- 2 650 710
- US-A1- 2018 059 329
- US-A1- 2018 259 710
- LAMPONI M ET AL: "Low-Threshold Heterogeneously Integrated InP/SOI Lasers With a Double Adiabatic Taper Coupler", IEEE PHOTONICS TECHNOLOGY LETTERS, IEEE, USA, vol. 24, no. 1, 1 janvier 2012 (2012-01-01), pages 76-78, XP011507756, ISSN: 1041-1135, DOI: 10.1109/LPT.2011.2172791

## Description

L'invention concerne une puce photonique et un procédé de fabrication de cette puce photonique.

Des puces photoniques connues comportent une source laser à semi-conducteur apte à générer un signal optique. Une telle source laser comporte un guide d'onde en matériau à gain III-V optiquement couplé, par l'intermédiaire d'un coupleur optique, à un guide d'onde en silicium. Un tel coupleur optique comporte, en vis-à-vis l'un de l'autre :
- un premier prolongement en matériau III-V qui prolonge le coeur du guide d'onde en matériau à gain III-V à l'intérieur d'une zone de couplage optique, et
- un second prolongement en silicium qui prolonge le coeur du guide d'onde en silicium à l'intérieur de la zone de couplage optique.

Pour obtenir un couplage optique entre ces deux prolongements, une région du second prolongement doit présenter un indice effectif de propagation égal à celui du premier prolongement situé en vis-à-vis. A dimensions égales, l'indice effectif de propagation du silicium est bien plus petit que l'indice effectif de propagation du matériau III-V. Dès lors, pour obtenir une égalité entre les indices effectifs de propagation des régions en vis-à-vis en silicium et en matériau III-V, il faut que les dimensions de la région en silicium soient grandes. Cela augmente l'encombrement du coupleur optique et, en particulier, l'épaisseur du prolongement en silicium.

Par ailleurs, les puces photoniques sont souvent fabriquées à partir d'un substrat SOI ("Silicon On Insulator"). L'épaisseur de la couche en silicium monocristallin d'un tel substrat SOI est fixée à l'avance. Aujourd'hui, cette épaisseur est couramment inférieure ou égale à 350 nm. Cette épaisseur est inférieure à celle souhaitée pour le prolongement en silicium du coupleur optique. Cela rend ce coupleur optique plus difficile à réaliser à partir d'un tel substrat SOI car sa fabrication requière le dépôt d'une surépaisseur de silicium monocristallin pour atteindre localement une épaisseur supérieure à 350 nm. Par exemple, cette solution est divulguée dans la demande US20210149228.

Par ailleurs, de l'état de la technique est connu de :
- LAMPONI M et AL : « Low-Threshold Heterogeneously Integrated InP/SOI Lasers With a Double Adiabatic Taper Coupler », IEEE Photonics Technology Letters, Vol. 24, n° 1.1, 01/01/2012, pages 76-78 ;
- US2018059329A1 ;
- US2018259710A1 ;
- EP2650710A2.

L'invention vise à proposer une puce photonique dans laquelle l'encombrement du coupleur optique entre un guide d'onde en silicium et un guide d'onde en matériau III-V est réduit.

Elle a donc pour objet une telle puce photonique conforme à la revendication 1.

L'invention a également pour objet un procédé de fabrication de cette puce photonique.

L'invention sera mieux comprise à la lecture de la description qui va suivre, donnée uniquement à titre d'exemple non limitatif et faite en se référant aux dessins sur lesquels :
- la figure 1 est une illustration schématique d'une puce photonique en coupe verticale ;
- la figure 2 est une illustration schématique, en vue de dessus, d'un coupleur optique entre un guide d'onde en silicium et un guide d'onde en matériau à gain III-V, ce coupleur optique étant mis en oeuvre dans la puce photonique de la figure 1 ;
- les figures 3 à 6 sont des illustrations schématiques de différentes sections transversales du coupleur optique de la figure 2;
- la figure 7 est une illustration schématique, en coupe longitudinal, du coupleur optique de la figure 2;
- la figure 8 est un organigramme d'un procédé de fabrication de la puce photonique de la figure 1 ;
- les figures 9 à 16 sont des illustrations schématiques, en coupe verticale, de différents états de fabrication du coupleur optique de la figure 2 obtenus lors de la mise en oeuvre du procédé de la figure 8.

Dans ces figures, les mêmes références sont utilisées pour désigner les mêmes éléments. Dans la suite de cette description, les caractéristiques et fonctions bien connues de l'homme du métier ne sont pas décrites en détail.

Par la suite, les définitions de certains termes et expressions utilisées dans cette demande sont données dans un chapitre I. Ensuite, des exemples détaillés de modes de réalisation sont décrits dans un chapitre II en référence aux figures. Dans le chapitre III suivant, des variantes de ces modes de réalisation sont présentées. Enfin, les avantages des différents modes de réalisation sont présentés dans un chapitre IV.

### Chapitre I : Terminologie et définitions

Dans cette description, lorsque l'on indique qu'un guide d'onde est réalisé en matériau X, cela signifie que le coeur de ce guide d'onde est réalisé dans ce matériau X. La gaine de ce guide d'onde est réalisée dans un autre matériau d'indice de réfraction plus faible.

Lorsqu'on indique qu'un élément "est réalisé en matériau X", cela signifie que le matériau X représente plus de 90% ou 95% ou 98% de la masse de cet élément.

L'indice effectif n_{eff} de propagation est aussi connu sous le nom de « constante de phase du mode ». Il est défini par la relation suivante : n_{g} = n_{eff}-λdn_{eff}/dλ, où n_{g} est l'indice de groupe et λ est la longueur d'onde du signal optique guidé par le guide. L'indice effectif de propagation d'un guide d'onde dépend des dimensions du coeur de ce guide d'onde et des matériaux formant ce coeur et la gaine de ce guide d'onde. Il peut être déterminé expérimentalement ou par simulation numérique.

La gaine d'un guide d'onde est généralement réalisée en matériau diélectrique. Dans ce cas le matériau diélectrique est un matériau diélectrique dont l'indice n_{md} de réfraction est plus petit que l'indice n_{Si} si le coeur du guide d'onde est en silicium et que l'indice n_{III-V} si le coeur est en matériau III-V, où n_{Si} et n_{III-V} sont les indices de réfraction, respectivement, du silicium et du matériau III-V. Typiquement, l'indice n_{md} est inférieur ou égal à 0,85n_{c} ou inférieur ou égal à 0,75n_{c}, où n_{c} est l'indice de réfraction du coeur du guide d'onde.

La largeur d'un élément désigne ici la largeur de cet élément mesurée dans une direction horizontale perpendiculaire à la direction de propagation du signal optique dans cet élément.

Une section transversale d'un élément est une section perpendiculaire à la direction de propagation du signal optique dans cet élément.

### Chapitre II : Exemples de modes de réalisation

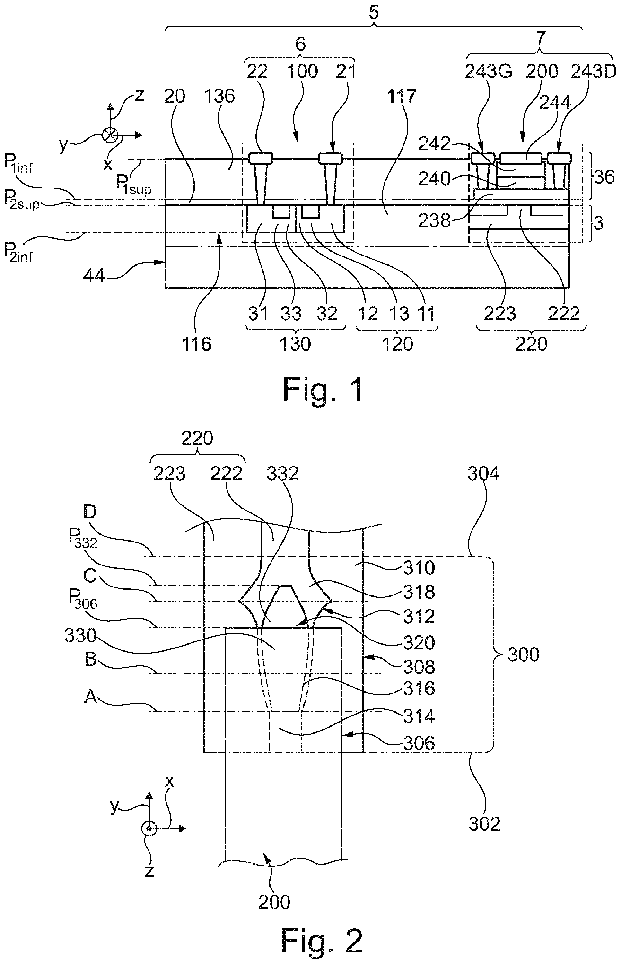

La figure 1 représente une puce photonique 5. Dans ce mode de réalisation particulier, la puce photonique 5 est un transmetteur d'un signal optique modulé en phase et/ou en amplitude pour transmettre des bits d'informations vers un récepteur par l'intermédiaire d'une fibre optique. A cet effet, la puce 5 comporte une source laser 7 qui émet un signal optique dont la phase et/ou l'amplitude est ensuite modulée par un système 6 de modulation de phase et/ou d'amplitude de ce signal optique. Par exemple, la longueur d'onde λ_{Li} du signal optique émis par la source laser 7 est comprise entre 1240 nm et 1630 nm. Ici, la longueur d'onde λ_{Li} est égale à 1550 nm.

La figure 1 représente les éléments de la puce 5 en coupe dans un plan vertical parallèle aux directions X et Z.

Sur la figure 1 et les figures suivantes, l'horizontal est représenté par des directions X et Y d'un repère orthogonal. La direction Z de ce repère orthogonal représente la direction verticale. Par la suite, les termes tels que « supérieur », « inférieur », « au-dessus », « en dessous », « haut » et « bas » sont définis par rapport à cette direction Z. Les termes « gauche » et « droite » sont définis par rapport à la direction X. Les termes « avant » et « arrière » sont définis par rapport à la direction Y.

Par la suite, le terme "épaisseur" désigne l'épaisseur maximale d'un élément dans la direction Z.

Le système 6 peut être un système de modulation de la phase seule, ou de l'amplitude seule ou simultanément de la phase et de l'amplitude.

Pour moduler la phase ou l'amplitude du signal optique, le système 6 comporte au moins un modulateur de phase et, souvent, au moins un dispositif d'accord de phase. Par exemple, le système 6 est un interféromètre de Mach-Zehnder dans lequel le modulateur et le dispositif d'accord de phase sont agencés dans l'une des branches de cet interféromètre pour moduler l'amplitude et/ou la phase du signal optique généré par la source laser 7. Les structures d'un interféromètre de Mach-Zehnder et d'un dispositif d'accord de phase sont bien connues et ne sont pas décrites ici en détail. Le dispositif d'accord de phase est par exemple le même que celui décrit dans la demande US2017237229A1. Par conséquent, pour simplifier la figure 1, seul un modulateur 100 de phase est représenté.

Le modulateur 100 permet de modifier rapidement la phase du signal optique. A cet effet, le modulateur 100 est ici un modulateur à jonction PN (Positif-Négatif). Il comporte donc deux électrodes 120 et 130.

Les électrodes 120 et 130 sont en silicium monocristallin dopé. Dans ce mode de réalisation, elles sont entièrement structurées dans le silicium monocristallin d'une couche 3.

La couche 3 comporte du silicium monocristallin encapsulé dans un matériau diélectrique 117. Généralement, un matériau diélectrique a une conductivité électrique à 20 °C inférieure à 10⁻⁷S/m et, de préférence, inférieure à 10⁻⁹S/m ou 10⁻¹⁵S/m. De plus, dans le cas du matériau diélectrique 117, son indice de réfraction est strictement inférieur à l'indice de réfraction du silicium. Par exemple, dans ce mode de réalisation, le matériau diélectrique 117 est du dioxyde de silicium (SiO₂). La couche 3 s'étend principalement dans un plan horizontal. La couche 3 est directement située sur un substrat rigide 44.

Le substrat 44 s'étend principalement dans un plan horizontal appelé « plan du substrat ». Dans cet exemple de réalisation, le substrat 44 est un support dont l'épaisseur est typiquement supérieure à 200 µm ou 400 µm. Par exemple, substrat 44 est un support en silicium de 725µm.

Dans la couche 3, le silicium monocristallin s'étend verticalement depuis un plan inférieur horizontal P2_{inf} jusqu'à un plan supérieur horizontal P₂ₛᵤₚ. Le plan P₂ₛᵤₚ est situé au niveau de l'interface entre la couche 3 et une couche 20 en matériau diélectrique située directement dessus la couche 3. Le plan P_{2inf} est situé au-dessus de l'interface entre la couche 3 et le substrat 44. Ainsi, le silicium monocristallin de la couche 3 est également isolé mécaniquement et électriquement du substrat 44 par le matériau diélectrique 117. Par exemple, l'épaisseur de silicium monocristallin dans la couche 3 est comprise entre 100 nm et 400 nm. Classiquement, l'épaisseur de silicium monocristallin est égale à 220 nm ou 280nm ou 310 nm. Dans cet exemple, l'épaisseur du silicium monocristallin dans la couche 3 est égale à 310 nm.

L'électrode 120 s'étend, dans la direction X, depuis une extrémité proximale 12 jusqu'à une extrémité distale 11. Elle s'étend également dans la direction Y. L'électrode 120 est dopée. Typiquement, la concentration de dopant dans l'électrode 120 est comprise entre 10¹⁷ et 10²¹ atomes/cm³.

L'épaisseur e₁₂ de l'extrémité proximale 12 est égale à l'épaisseur du silicium monocristallin encapsulé dans la couche 3. Cette épaisseur e₁₂ est donc égale à 310 nm. L'épaisseur e₁₁ de l'extrémité distale est ici égale à l'épaisseur e₁₂.

L'électrode 120 comporte également un pont 13 en silicium monocristallin dopé qui raccorde mécaniquement et électriquement les extrémités 11 et 12. Ici, l'épaisseur e₁₃ de ce pont est inférieur à l'épaisseur e₁₂.

L'électrode 130 est également réalisée en silicium monocristallin dopé avec un dopage de signe opposé à celui de l'électrode 120. La concentration en dopant de l'électrode 130 est comprise, par exemple, entre 10¹⁷ atomes/cm³ et 2 × 10¹⁹ atomes/cm³.

L'électrode 130 s'étend, parallèlement à la direction X, depuis une extrémité proximale 32 jusqu'à une extrémité distale 31 en passant par l'intermédiaire d'un pont 33. L'électrode 130 s'étend également dans la direction Y. Les épaisseurs des extrémités 31 et 32 sont égales aux épaisseurs, respectivement, des extrémités 11 et 12. L'épaisseur du pont 33 est égale à l'épaisseur du pont 13. L'extrémité proximale 32 comporte une face verticale qui est directement en appui sur une face verticale de l'extrémité proximale 12 pour former la jonction PN.

Par rapport à un plan vertical parallèle aux directions Y et Z et passant par la jonction PN, les extrémités distales 11 et 31 sont les extrémités les plus éloignées de ce plan.

Les extrémités proximale 12 et 32 sont conformées pour que leur juxtaposition forme un guide d'onde capable de guider, dans la direction Y, le signal optique généré par la source laser 7. Ce guide d'onde est typiquement raccordé optiquement à la source laser 7 par l'intermédiaire d'autres guides d'onde et d'autres coupleurs structurés dans la couche 3. Pour simplifier la figure 1, ces autres guides d'onde et autres coupleurs n'ont pas été représentés.

Le modulateur 100 comporte aussi deux prises de contact 21 et 22, en contact mécanique et électrique directement avec, respectivement, les extrémités distales 11 et 31. Ces prises 21 et 22 sont raccordées à une source de tension pilotable en fonction du bit ou des bits d'informations à transmettre par la puce 5.

Typiquement, la source laser 7 est un laser DBR (« Distributed Bragg Reflector laser ») ou DFB (« Distributed FeedBack laser »). Une telle source laser est bien connue et seuls les détails nécessaires pour la compréhension de l'invention sont décrits ici. Par exemple, pour des détails généraux et le fonctionnement d'une telle source laser, le lecteur peut se référer aux articles suivants :
- B. Ben Bakir et al., « Hybrid Si/III-V lasers with adiabatic coupling », 2011.
- B. Ben Bakir, C. Sciancalepore, A. Descos, H. Duprez, D. Bordel, L. Sanchez, C. Jany, K. Hassan, P. Brianceau, V. Carron, and S. Menezo, « Heterogeneously Integrated III-V on Silicon Lasers », Invited Talk ECS 2014.

Pour simplifier la figure 1 et les figures suivantes, seul un guide d'onde laser hybride 200, 220 de la source laser 7 est représenté.

Le guide d'onde laser hybride 200, 220 est constitué d'un guide d'onde 200 réalisé dans un matériau à gain III-V et d'un guide d'onde 220 en silicium. Généralement le guide d'onde 200 est utilisé pour générer et amplifier un signal optique à l'intérieur d'une cavité optique de la source laser 7. Ici, à cet effet, il est réalisé dans une couche 36 comportant un matériau à gain III-V encapsulé dans un matériau diélectrique 136. Par exemple, le matériau 136 est du dioxyde de silicium ou du nitrure de silicium. Cette couche 36 s'étend horizontalement directement sur la couche 20 en matériau diélectrique.

A l'intérieur de la couche 36, le matériau à gain III-V s'étend verticalement depuis un plan horizontal inférieur P_{1inf} jusqu'à un plan horizontal supérieur P₁ₛᵤₚ. Le plan P_{1inf} est situé au niveau de l'interface entre les couches 20 et 36. Le plan P₂ₛᵤₚ est situé en-dessous de la face supérieure de la couche 36. Ainsi, le matériau à gain III-V de la couche 36 est également isolé mécaniquement et électriquement de la face supérieure de la couche 36.

Le guide 200 comprend typiquement une bande inférieure dopée 238, un empilement 240 de puits quantiques ou boites quantiques en quaternaire et une bande supérieure 242 dopée avec un dopant de signe opposé à celui de la bande 238. Les bandes 238 et 242 sont par exemple ici en alliage InP monocristallin dopé N ou P. Dans ce cas, l'empilement 240 est, par exemple, un empilement en alternance de sous-couches en InGaAsP ou en AlGaInAs ou autre.

Le guide d'onde 200 comporte également :
- des prises 243G et 243D de contact en contact mécanique et électrique directement avec la bande 238 et situées, respectivement, à gauche et à droite de l'empilement 240, et
- une prise 244 de contact en contact mécanique et électrique directement avec la bande 242.

Ces prises 243G, 243D et 244 permettent d'injecter un courant électrique dans le guide 200 entre les prises 243G, 243D et la prise 244.

Le guide 220 s'étend sous le guide 200. Il est séparé du guide 200 par la couche 20 en matériau diélectrique. Le guide 220 est entièrement situé à l'intérieur de la couche 3 et s'étend ici depuis le plan P_{2inf} jusqu'au plan P₂ₛᵤₚ. Dans la figure 1, le guide 220 est représenté, à titre d'illustration, dans le cas où la direction de propagation du signal optique à l'intérieur de ce guide d'onde est parallèle à la direction Y.

Ici, le guide 220 adopte une conformation connue sous l'expression de "guide d'onde à arête" ou sous le terme anglais de « RIB waveguide». Ainsi, dans la section transversale de ce guide d'onde, parallèlement au plan XZ, il comporte une arête 222 ("strip" en anglais) et une dalle 223 ("slab" en anglais). La face horizontale inférieure de la dalle 223 s'étend dans le plan P_{2inf}. La face horizontale supérieure de l'arête 222 s'étend dans le plan P₂ₛᵤₚ. Dès lors, l'épaisseur totale e₂₂₀ du guide 220 est égale à l'épaisseur e₁₂ des électrodes du modulateur 100. L'arête 222 forme une excroissance sur la face supérieure de la dalle 223. Ainsi, sa largeur est inférieure à la largeur de la dalle 223. La face horizontale inférieure de l'arête 222 et la face horizontale supérieure de la dalle 223 sont toutes les deux contenues dans un plan horizontale intermédiaire situé entre les plans P_{2inf} et P₂ₛᵤₚ. Par exemple, ici, l'épaisseur de la dalle 223 est de 150 nm et l'épaisseur de l'arrêté 222 est de 160 nm.

Le guide 220 est raccordé optiquement au guide 200 par au moins un coupleur optique. Ce coupleur optique transfère, à travers la couche 20, K % de la puissance du signal optique qui se propage dans le guide 200 vers le guide 220 est vice-versa. Typiquement, le coefficient K est supérieur ou égal à 50% et, ici, supérieur à 80 % ou 90%. Par exemple, dans ce mode de réalisation, la source laser 7 comporte un premier et un second coupleurs optiques. Dans un sens de propagation du signal optique, le premier coupleur optique transfert le signal optique d'une première partie du guide 220 vers le guide 200 et le second coupleur optique transfert le signal optique du guide d'onde 200 vers une seconde partie du guide 220. Ces deux coupleurs optiques sont, par exemple, structurellement identiques. Ainsi, par la suite seul l'un de ces coupleurs optiques est décrit en détail.

Dans ce mode de réalisation, le coupleur optique réalise un couplage adiabatique entre les guides 200 et 220. Pour une description détaillée d'un couplage adiabatique le lecteur peut se référer à l'article suivant : Amnon Yariv et al., « Supermode Si/III-V hybrid Lasers, optical amplifiers and modulators: proposal and analysis » Optics Express 9147, vol. 14, No. 15, 23/07/2007. Un tel couplage adiabatique est avantageux en ce qu'il n'est pas nécessaire de réaliser une terminaison en pointe dans le matériau à gain III-V pour assurer un bon échange de puissance optique entre les guides 200 et 220, ainsi que pour réduire la longueur de couplage. Ces terminaisons en pointe sont connues sous le terme anglais de « tapera ».

Pour obtenir un tel couplage adiabatique entre les guides 200 et 220, l'épaisseur e₂₀ de la couche 20 est choisie supérieure à 20 nm et, typiquement, comprise entre 20 nm et 250 nm ou entre 20 nm et 150 nm ou entre 20 nm et 80 nm. A titre d'illustration, ici, l'épaisseur e₂₀ est égale à 100 nm.

Un fonctionnement possible de la puce 5 est le suivant. La source laser 7 génère un signal optique. Au moins, une partie de ce signal optique est dirigée vers un interféromètre de Mach Zehnder dont au moins l'une des branches comporte le modulateur 100. Cette partie de signal optique est donc guidée par le modulateur 100 avant d'être recombinée avec une autre partie du signal optique guidée par l'autre branche de l'interféromètre de Mach Zehnder pour former le signal optique modulé.

La figure 2 représente en vue de dessus une portion des guides 200 et 220 et un coupleur optique 300 qui raccorde optiquement ces deux guides d'onde à travers la couche 20. Sur cette figure 2, seuls les coeurs des guides 200 et 220 sont représentés. Les gaines des guides d'onde ne sont pas représentées. Par la suite, le coupleur 300 est décrit dans le cas particulier où le signal optique se propage du guide 200 vers le guide 220 et donc dans la direction Y. Toutefois, ce coupleur 300 est bidirectionnel, c'est-à-dire qu'il permet aussi de transférer un signal optique du guide 220 vers le guide 200.

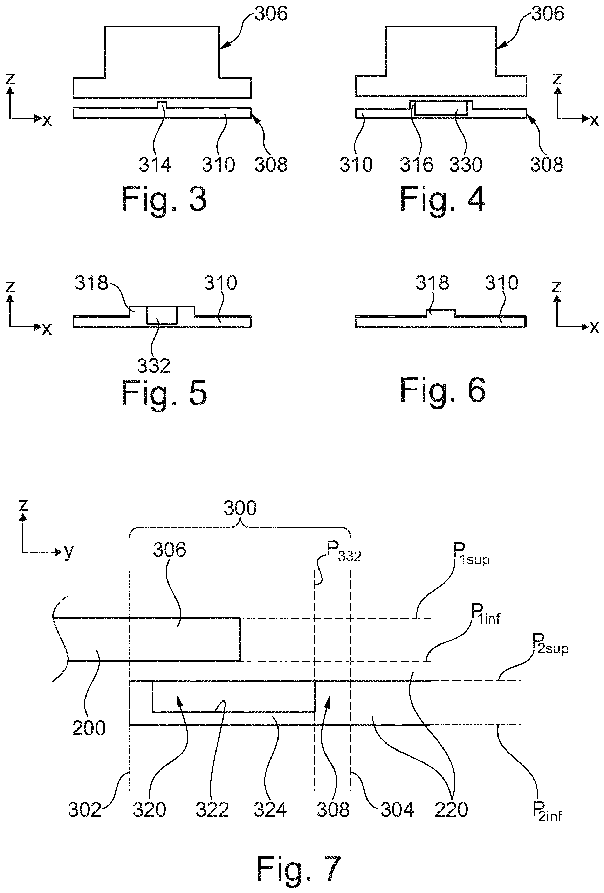

Sur la figure 2, les éléments visibles par transparence à travers un prolongement 306 sont représentés en lignes pointillées. Sur cette figure, les lignes en pointillés A à D représentent les positions, respectivement, de plans verticaux de coupe A à D. Les sections transversales du coupleur 300 correspondant aux plans de coupe A à D sont représentées, respectivement, sur les figures 3 à 6.

La figure 7 représente le coupleur 300 en coupe transversale, c'est-à-dire en coupe le long d'un plan vertical parallèle aux directions Y et Z et passant par le centre du coupleur 300.

Sur les figures 3 à 7 seuls les éléments réalisés en silicium, en matériau à gain III-V et en alliage SiGe sont représentés. Les matériaux diélectriques ne sont pas représentés.

Le coupleur 300 transfère le signal optique du guide d'onde de 200 vers le guide d'onde de 220 à l'intérieur d'une zone de couplage. Sur les figures 2 et 7, les limites 302 et 304 représentent, respectivement, le début et la fin de cette zone de couplage. Avant la limite 302 et après la limite 304, il n'existe plus de transfert de signal optique entre les deux guides 200 et 220.

Dans ce texte, les guides 200 et 220 s'arrêtent au niveau respectivement, des limites 302 et 304 et leurs prolongements à l'intérieur de la zone de couplage sont considérés comme faisant partir du coupleur 300. Ainsi, le coupleur 300 comporte :
- un prolongement 306 en matériau à gain III-V qui prolonge le guide 200 à l'intérieur de la zone de couplage et qui ne forme qu'un seul bloc de matière avec le guide 200 ;
- un prolongement 308 en silicium qui prolonge le guide 220 à l'intérieur de la zone de couplage et qui ne forme qu'un seul bloc de matière avec ce guide 220.

Le prolongement 306 est entièrement situé entre les plans P_{1inf} et P₁ₛᵤₚ. Le prolongement 306 s'étend continûment depuis plus le plan P_{1inf} jusqu'au plan P₁ₛᵤₚ. Dans ce mode de réalisation, la section transversale du prolongement 306 est constante et identique à la section transversale du guide 200. Le prolongement 306 s'arrête brutalement au niveau d'un plan vertical P₃₀₆ au-delà duquel le prolongement 306 n'existe plus. Le plan P₃₀₆ est perpendiculaire à la direction Y et situé ici entre les plan B et C. Dans ce mode de réalisation, le prolongement 306 ne comporte aucune terminaison en pointe.

Le prolongement 308 est entièrement situé entre les plans P_{2inf} et P₂ₛᵤₚ. Ce prolongement 308 comporte :
- une dalle 310 qui se situe dans le prolongement de la dalle 223, et
- une arête 312 qui se situe dans le prolongement de l'arête 222.

Ici, la dalle 310 et l'arête 312 s'étendent depuis la limite 304 jusqu'à la limite 302. Dans cet exemple de réalisation, le prolongement 308 s'arrête brutalement au niveau de la limite 302 et n'existe plus au-delà.

La face inférieure de la dalle 310 est contenue dans le plan P_{2inf}. Sa section transversale est identique à la section transversale de la dalle 223. Sa face supérieure est donc comprise entre les plans P_{2inf} et P₂ₛᵤₚ.

L'arête 312 s'étend à partir de la face supérieure de la dalle 310 jusqu'au plan P₂ₛᵤₚ. Au niveau de la limite 304, sa section transversale est identique à celle de l'arête 222. Ici, au niveau de la limite 302, sa section transversale est plus petite. Plus précisément, dans cet exemple de mode de réalisation, en se déplaçant dans la direction Y, l'arête 312 comporte immédiatement les unes après les autres :
- une portion 314 parallélépipédique de section transversale constante qui s'étend continûment depuis la limite 302 jusqu'au plan A,
- une portion 316 dans laquelle la largeur de l'arête 312 croît continûment et progressivement du plan A jusqu'au plan C, et
- une portion 318 dans laquelle la largeur de l'arête 312 décroît continûment et progressivement depuis le plan C jusqu'à la limite 304.

Ici, la largeur de la portion 314 est, par exemple 1,2 fois ou 1,5 fois inférieure à la largeur de l'arête 222.

Le coupleur 300 comporte aussi une inclusion 320 en SiGe enfoncée à l'intérieur du prolongement 308. Plus précisément, l'inclusion 320 est logée à l'intérieur d'un évidement 322 (figure 7) creusé dans le prolongement 308.

L'évidement 322 n'est pas traversant. Ainsi, sous l'inclusion 320, il subsiste une fine semelle 324 (figure 7) en silicium. Dans ce mode de réalisation, toutes les parois verticales de cet évidement 322 sont creusées dans les portions 316 et 318 de l'arête 312 et dans la dalle 310. Ainsi, les parois verticales de l'évidement 322 sont en silicium monocristallin.

Ici, l'inclusion 320 remplit entièrement l'évidement 322 jusqu'au plan P₂ₛᵤₚ. Les flancs verticaux de l'inclusion 320 sont directement mécaniquement en appui sur les parois verticales de l'évidement 322.

L'inclusion 320 est entièrement située entre les plans P_{2inf} et P₂ₛᵤₚ. Ici, la face supérieure de l'inclusion 320 est contenue dans le plan P₂ₛᵤₚ. Sa face inférieure est située au-dessus du plan P_{2inf} et séparée du plan P_{2inf} par la semelle 324. L'inclusion 320 comporte deux terminaisons 330 et 332 situées l'une après l'autre dans la direction Y.

La terminaison 330 est conformée pour transférer, par couplage adiabatique, le signal optique qui se propage dans le prolongement 306 vers l'inclusion 320. A cet effet, la terminaison 330 est une terminaison en pointe qui s'étend ici depuis le plan A jusqu'au plan P₃₀₆. La largeur de la terminaison 330 augmente progressivement et continûment depuis une largeur minimale Lₘᵢₙ₃₃₀ au niveau du plan A jusqu'à une largeur maximale Lₘₐₓ₃₃₀ au niveau du plan P₃₀₆.

La largeur Lₘᵢₙ₃₃₀ est choisie pour que l'indice effectif de propagation de la terminaison 330 au niveau du plan A soit inférieur à 0,9n_{eff306} et, de préférence, inférieur à 0,7n_{eff306}, où l'indice n_{eff306} est l'indice effectif de propagation du prolongement 306. Ici, l'indice n_{eff306} est constant sur toute la longueur du prolongement 306 entre la limite 302 et le plan P₃₀₆.

La largeur Lₘₐₓ₃₃₀ est choisie pour que l'indice effectif de propagation de la terminaison 330 au niveau du plan P₃₀₆ soit supérieur à 1,1n_{eff306} et, de préférence, supérieur à 1,4n_{eff306}.

Ainsi, puisque la largeur de la terminaison 330 croît progressivement en allant dans la direction Y, il existe nécessairement une région particulière de la terminaison 330, située entre les plans A et P₃₀₆, où l'indice effectif de propagation de cette terminaison est égal à l'indice n_{eff306}. C'est la présence en vis-à-vis de cette région particulière et d'une région correspondante du prolongement 306 qui permet le transfert du signal optique du prolongement 306 vers l'inclusion 320.

La terminaison 332 est conformée pour transférer le signal optique de l'inclusion 320 vers le prolongement 308. A cet effet, dans ce mode de réalisation, la terminaison 332 est aussi une terminaison en pointe. La terminaison 332 s'étend depuis le plan P₃₀₆ jusqu'à un plan vertical P₃₃₂. Le plan P₃₃₂ est perpendiculaire à la direction Y et situé entre les plans C et D. La largeur de la terminaison 332 décroît progressivement et continûment, en allant dans la direction Y, depuis une largeur maximale Lₘₐₓ₃₃₂, au niveau du plan P₃₀₆, jusqu'à une largeur minimale Lₘᵢₙ₃₃₂ au niveau du plan P₃₃₂.

La largeur maximale Lₘₐₓ₃₃₂ est ici égale à la largeur Lₘₐₓ₃₃₀.

La largeur Lₘᵢₙ₃₃₂ est choisie pour que l'indice effectif de propagation de la terminaison 332 au niveau du plan P₃₃₂ soit inférieur à 0,9n_{eff220} et, de préférence, inférieur à 0,7n_{eff220}, où l'indice n_{eff220} est l'indice effectif de propagation du guide 220. L'indice n_{eff220} est inférieur à l'indice n_{eff306}. Par conséquent, l'indice effectif de propagation de la terminaison 332 au niveau du plan P₃₀₆ est supérieur à l'indice n_{eff220}. Dans ces conditions, comme pour la terminaison 330, il existe nécessairement une région particulière de la terminaison 332 où son indice effectif de propagation est égal à l'indice n_{eff220}. C'est principalement dans cette région particulière où le transfert du signal optique de l'inclusion 320 vers le prolongement 308 et donc vers le guide 220 se produit.

A dimensions égales, l'indice effectif de propagation d'un guide d'onde en SiGe est supérieur à l'indice effectif de propagation d'un guide d'onde en silicium. Dès lors, la présence de l'inclusion 320 permet, avec des dimensions réduites, d'obtenir une région dont l'indice effectif de propagation est égal à l'indice n_{eff306}.

Par ailleurs, habituellement, les alliages en SiGe utilisés dans la fabrication de composants optiques, telles que des photodiodes, présentent des pertes par absorption importante. Or, dans le cadre d'un coupleur optique, les pertes par absorption doivent être limitées. Ici, pour obtenir à la fois un indice effectif de propagation élevé et des pertes de propagation faibles, l'inclusion 320 est réalisée dans un alliage SiGe dont la formule chimique est Si₁₋ₓGeₓ, où le coefficient x est compris entre 0,2 et 0,5. Le coefficient x est la concentration en pourcentages atomiques de germanium dans cet alliage, le reste étant du silicium aux impuretés inévitables près. La valeur 1 du coefficient x correspond à 100 % tandis que la valeur 0 de ce coefficient x correspond à 0 %. De préférence, le coefficient x est choisi entre 0,3 et 0,5 et, de façon encore plus avantageuse, entre 0,4 et 0,5. Dans cet exemple de réalisation, le coefficient x est égal à 0,4.

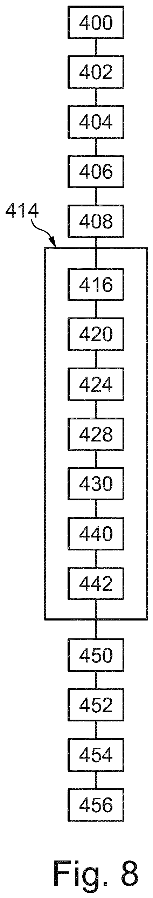

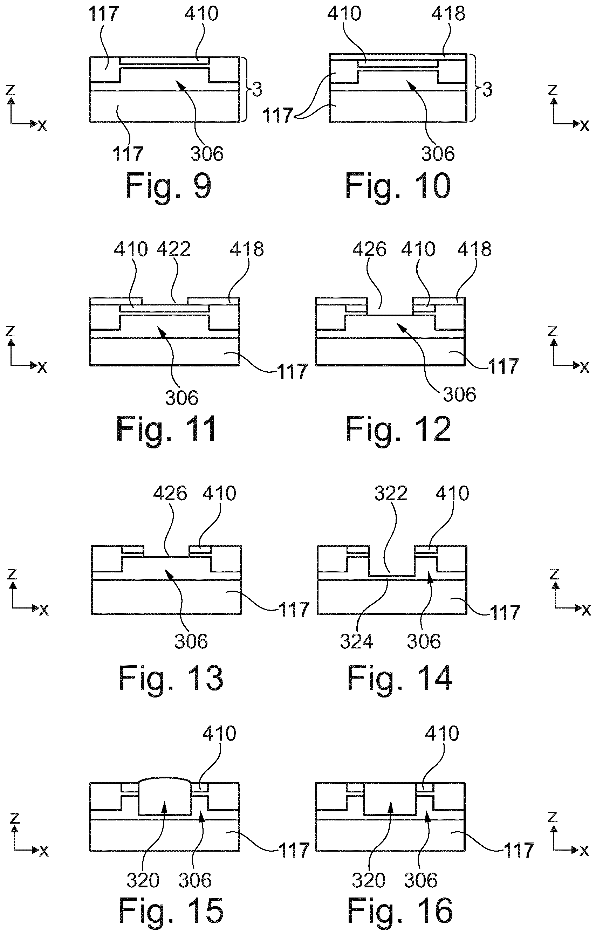

La fabrication de la puce 5 va maintenant être décrite à l'aide de l'organigramme de la figure 8 et en référence aux figures 9 à 16. Sur les figures 9 à 16, le substrat 44 n'a pas été représenté.

La fabrication du modulateur 100 et des guides d'onde 200 et 220 est bien connue. Ainsi, seules les étapes de fabrication du coupleur 300 sont décrites plus en détail.

Le procédé débute par une étape 400 de fourniture d'un substrat SOI correspondant à l'empilement du substrat 44, d'une couche enterrée en matériau diélectrique et d'une couche en silicium monocristallin. L'épaisseur initiale de la couche en silicium monocristallin est ici de 310 nm. L'épaisseur de la couche enterrée en matériau diélectrique est supérieure à 500 nm ou 1 µm et, généralement, inférieure à 3 µm.

Ensuite, lors d'une étape 402, la couche en silicium monocristallin est structurée pour réaliser notamment les électrodes 120, 130, le coeur du guide d'onde 220 et le prolongement 308 dépourvu de l'évidement 322.

Lors d'une étape 404, les électrodes 120 et 130 sont dopées pour obtenir les différentes zones de dopage souhaitées. Typiquement, ceci est réalisé par des opérations de dopage localisé.

Lors d'une étape 406, la couche en silicium monocristallin structurée est encapsulée dans le matériau diélectrique 117, puis la face supérieure du matériau 117 est polie.

Lors d'une étape 408, une couche d'arrêt 410 (Figures 9 à 16) est déposée sur le matériau 117. Cette couche 410 est réalisée dans un matériau diélectrique différent du matériau diélectrique 117. De plus, ici, cette couche 410 est réalisée dans un matériau sur lequel l'alliage SiGe ne peut pas croître lors d'une opération de croissance de cet alliage par épitaxie en phase vapeur. Par exemple, la couche 410 est réalisée en nitrure de silicium. Son épaisseur est typiquement supérieure ou égale à 20 nm et, généralement, inférieure à 200 nm. Ici, l'épaisseur de la couche 410 est de 40 nm.

Une section transversale du prolongement 308 obtenue à l'issue des étapes précédentes est représentée sur la figure 9.

A ce stade, lors d'une étape 414, l'inclusion 320 est réalisée dans le prolongement 308. La réalisation de l'inclusion 320 comporte successivement les opérations suivantes.

Lors d'une opération 416, une couche 418 (Figure 10) de résine photosensible est déposée sur la face supérieure de la couche 410.

Lors d'une opération 420, un trou 422 (Figure 11) qui traverse de part en part l'épaisseur de la couche 418 de résine est réalisé pour mettre à nu la portion de la face supérieure de la couche 410 à graver. La section horizontale du trou 422 est identique à la section horizontale de l'inclusion 320 à fabriquer.

Lors d'une opération 424, la couche 410 est gravée à travers le trou 422 pour obtenir une cavité 426 (Figure 12) qui débouche directement sur la face supérieure du prolongement 308.

Lors d'une opération 428, la couche 418 de résine photosensible est retirée (Figure 13).

Lors d'une opération 430, la cavité 426 (figure 14) est prolongée, dans la direction verticale, à l'intérieur du prolongement 308 pour former l'évidement 322. Lors de cette opération 430, la couche 410 est utilisée comme un masque, c'est-à-dire que le prolongement 308 est gravée à travers la couche 410. La gravure du prolongement 308 est interrompue avant d'atteindre le matériau diélectrique 117 de sorte qu'il subsiste une fine couche de silicium d'au moins 30 nm d'épaisseur entre le fond de l'évidement 322 et le matériau diélectrique 117. Ici, l'épaisseur de cette fine couche est égale à 50 nm. Cette fine couche forme donc la semelle 324 en silicium.

Lors d'une opération 440, l'évidement 322 est remplit d'alliage SiGe de formule chimique identique à celle de l'inclusion 320. Pour cela, une opération de croissance épitaxiale en phase vapeur de l'alliage SiGe sur la semelle 324 est mise en oeuvre. Cette opération est interrompue une fois que l'évidement 322 est entièrement rempli par l'alliage SiGe. L'inclusion 320 est alors réalisée. A ce stade, comme représenté sur la figure 15, la face supérieure de l'inclusion 320 est bombée.

Lors d'une opération 442, la face supérieure de l'inclusion 320 est polie. Par exemple un polissage mécanico-chimique ou CMP (Chemical Mecanical Polissing) est mis en oeuvre pour éliminer l'épaisseur d'alliage SiGe qui dépasse au-delà de l'évidement 322 sans pour autant retirer l'épaisseur de SiGe logé à l'intérieur de cet évidement. Lors de ce polissage CMP, la couche 410 est utilisée comme couche d'arrêt du polissage. A l'issue de cette opération, la face supérieure de l'inclusion 320 est plane et confondue avec la face supérieure de la couche 410 (Figure 16). A ce stade, la réalisation de l'inclusion 320 est terminée.

Ensuite, lors d'une étape 450, la couche 20 est déposée sur la face polie.

Lors d'une étape 452, un substrat ou une vignette en matériau à gain III-V est rapporté, par collage direct, sur la couche 20 puis structuré pour réaliser le guide 200 et le prolongement 306.

Ensuite, lors d'une étape 454, le guide 200 et le prolongement 306 sont encapsulés dans le matériau diélectrique 136.

Enfin, lors d'une étape 456, les prises de contact 21, 22, 243D, 243G et 244 sont réalisées.

### Chapitre II : Variantes

### Variantes de l'inclusion :

En variante, le prolongement 306 comporte lui aussi une terminaison en pointe, de sorte que par exemple, la largeur du prolongement 306 diminue progressivement et continûment en allant dans la direction Y.

Dans un autre mode de réalisation, le prolongement 306 se poursuit au-delà du plan P₃₀₆ par une partie courbée. Cette partie courbée s'éloigne du prolongement 308. Ainsi, au-delà du plan P₃₀₆, le prolongement 306 n'est plus situé au-dessus du prolongement 308, ce qui évite tout transfert de puissance entre cette partie courbée et le prolongement 308.

En variante, le prolongement 308 se poursuit au-delà de la limite 302 par une portion du guide d'onde 220 capable de guider la partie du signal optique qui n'a pas été transférée, par le coupleur 300, vers le guide 200 lorsque le signal se propage en sens inverse de la direction Y.

Dans un autre mode de réalisation, la largeur de la portion 314 de l'arête 312 est égale à la largeur de l'arête 222 du guide 220.

Dans des modes de réalisations simplifiés, la portion 314 et/ou la portion 316 de l'arête 312 sont omises.

En variante, le plan P₃₀₆ et le plan C sont confondus. Dans ce cas, la portion 318 de l'arête 312 et la terminaison 332 de l'inclusion 320 débute dans le même plan.

En variante, l'inclusion 320 ne remplit pas, sur toute sa hauteur, l'évidement 322. Dans ce cas, la face supérieure de l'inclusion 320 est située en-dessous du plan P₂ₛᵤₚ. L'espace entre la face supérieure de l'inclusion 320 et ce plan P₂ₛᵤₚ est alors rempli de matériaux diélectriques comme, par exemple, le matériau 117. Dans ce cas, la face supérieure de l'inclusion 320 peut rester bombée, car elle n'est pas polie lors de l'opération 442.

En variante, une ou plusieurs fines couches d'interface sont déposées sur la semelle 324 avant de faire croître par épitaxie, l'alliage SiGe. Cette ou ces fines couches d'interface sont typiquement des couches d'adaptation de paramètre de maille qui ont pour fonction de limiter l'apparition de dislocations dans l'alliage SiGe déposé lors de sa croissance par épitaxie. L'épaisseur totale de cette ou de ces fines couches d'interface est généralement inférieure à 10 % de l'épaisseur de l'inclusion 320. Dans ce cas, l'inclusion 320 n'est pas directement déposée sur la semelle 324 en silicium.

La face supérieure de l'inclusion 320 peut aussi être recouverte d'une ou plusieurs fines couches de passivation.

Le couplage optique entre la terminaison 330 et le prolongement 306 peut être réalisé différemment. Par exemple, en variante, la terminaison 330 est optiquement couplée au prolongement 306 par un couplage directionnel ou évanescent. Dans ce cas, la largeur de la terminaison 330 est par exemple constante entre le plan A et le plan P₃₀₆. Cette largeur est alors choisie pour que l'indice effectif de propagation de la terminaison 330 soit égal à l'indice n_{eff306} sur toute sa région comprise entre le plan A et le plan P₃₀₆. Dans ce cas, la terminaison 330 n'est donc pas une terminaison en pointe. De plus, dans ce cas, c'est la longueur de la terminaison 330 et la distance constante qui le sépare du prolongement 306 qui sont ajustées pour transférer la quantité souhaitée du signal optique de l'inclusion 320 vers le guide 200 et vice versa.

D'autres modes de réalisation de la terminaison 332 sont possibles. Par exemple, en variante, la terminaison 332 n'est pas une terminaison en pointe. Dans ce cas, la largeur de la terminaison 332 est constante sur toute sa longueur. La largeur de la terminaison 332 est alors choisie pour que, au niveau de son extrémité distale, son indice effectif de propagation soit égal à l'indice n_{eff220}. Dans ces conditions, l'essentiel du signal optique qui passe de l'inclusion 320 vers le prolongement 308 passe à travers un flanc vertical de l'inclusion 320 contenu dans le plan C. Ce type de couplage optique est connu sous le terme anglais de *« butt coupling ».*

Au niveau des extrémités distales des terminaisons 330 et 332, la largeur de la terminaison en question peut être plus petite ou plus grande que ce qui a été représenté. Dans un cas particulier, la largeur de la terminaison au niveau de son extrémité distale est pratiquement nulle, c'est-à-dire très petite et, par exemple, inférieure à 10 nm.

En variante, les portions 316 et 318 qui recouvrent les parties supérieures des flancs latéraux de l'inclusion 320, sont omises. Lorsque la portion 318 est omise, la terminaison 332 se prolonge jusqu'à l'arête 222. Ainsi, dans ce cas, le plan P₃₃₂ est confondu avec le plan D.

En variante, l'inclusion 320 comporte une portion de section transversale constante située entre les terminaisons 330 et 332.

En variante, au-delà du plan P₃₃₂, le coupleur 300 comporte des motifs alignés les uns derrière les autres dans la direction Y de propagation du signal optique à la longueur d'onde λ_{Li}. Chaque motif est réalisé en SiGe et entièrement encapsulé dans le prolongement 308. Les dimensions horizontales de ces motifs sont inférieures à la longueur d'onde λ_{Li}. De plus, la longueur de ces motifs dans la direction Y diminue au fur et à mesure que l'on s'éloigne du plan P₃₃₂. La section transversale de chaque motif est par exemple rectangulaire.

### Variantes du procédé de fabrication :

D'autres procédés de fabrication du coupleur 300 sont possibles. Par exemple, dans le cas où les portions 316 et 318 de l'arête 312 sont omises, une partie substantielle des parois verticales de l'évitement 322 sont réalisées dans le matériau 117 et non pas en silicium. Dans ce cas, si l'épaisseur de la dalle 310 fabriquée lors de l'étape 402 est suffisamment petite, c'est-à-dire inférieure à 100 nm ou 60 nm, il n'est pas nécessaire d'amincir encore plus cette dalle 310 pour obtenir la semelle 324. L'opération 430 de gravure de la dalle 310 peut donc être omise. Dans ce cas, la cavité 426 obtenue à l'issue de l'opération 424 constitue directement l'évidement 322 souhaité.

Dans un autre mode de réalisation, la couche 410 au-dessus du prolongement 306 est omise et c'est le même masque réalisé dans la couche 418 de résine photosensible qui est utilisé pour creuser la cavité 426 puis l'évidement 322.

En variante, après l'étape 450 de dépôt d'une fine couche de matériau diélectrique, un substrat, par exemple identique au substrat 44, est collé sur cette fine couche. La puce 5 en cours de fabrication est alors retournée, puis le substrat 44 est éliminé. Éventuellement, la couche 3 est amincie pour ne laisser subsister qu'une fine épaisseur du matériau 117. Cette fine épaisseur du matériau 117 forme alors la couche 20. Ensuite, les étapes 452, 454 et 456 sont exécutées sur la face supérieure de la couche 20 ainsi formée. Dans cette variante, l'opération 450 permet d'obtenir l'épaisseur du matériau 117 qui est située entre le plan P_{2inf} et la face supérieure du substrat.

Dans la variante ci-dessus, les prises de contact 21 et 22 peuvent être réalisées chacune en deux parties. Pour cela, une première partie de chacune de ces prises de contact est réalisée dans le substrat qui est rapporté par collage et avant le retournement de la puce 5. Chaque première partie s'étend alors depuis une électrode respective du modulateur 100 jusqu'à une piste électrique respective réalisée sur la face extérieure du substrat rapporté par collage. Ensuite, lors de l'étape 456, la deuxième partie des prises de contact 21 et 22 est réalisée. Cette deuxième partie traverse complètement les couches 36 et 3, et le substrat rapporté par collage pour venir atteindre les pistes électriques qui forment, à ce stade, les extrémités inférieures des premières parties de ces prises de contact.

### Autres variantes :

En variante, seule une partie du signal optique est transférée du guide 200 vers le guide 220 et vice versa. Dans ce cas, généralement, le guide d'onde dans lequel une partie du signal optique subsiste se prolonge alors au-delà de la zone de couplage pour continuer à guider cette partie du signal optique qui n'a pas été transférée vers l'autre guide d'onde.

D'autres conformations du guide d'onde 220 sont possibles. Par exemple, en variante la largeur de l'arête 222 est égale à la largeur de la dalle 223. Dans ce cas, la conformation du guide d'onde 220 est connue sous le terme de "guide d'onde en bande" ou, en anglais, de "strip waveguide". Dans un autre mode de réalisation, la largeur de l'arête 222 est plus grande que la largeur de la dalle 223. Dans ce cas, la conformation du guide d'onde 220 est toujours un guide d'onde à arête mais les positions de l'arête et de la dalle sont inversées par rapport au mode de réalisation de la figure 1.

D'autres modes de réalisation du modulateur 100 sont possibles. Par exemple, le modulateur peut être remplacé par un modulateur à jonction PiN (Positive intrinsic Négative) dans lequel les électrodes dopées P et N sont séparées par une zone semi-conductrice non dopée dite « *intrinsèque ».* Les zones dopées peuvent aussi être séparées par une fine couche en matériau diélectrique comme de l'oxyde de silicium. Dans ce dernier cas, l'électrode 130 peut être située entre les plans P_{1inf} et P₁ₛᵤₚ de sorte que son extrémité proximale 32 est séparée de l'extrémité proximale 12 par la couche 20 en matériau diélectrique.

Les ponts 13 et 33 peuvent être omis.

D'autres matériaux à gain III-V sont possibles pour réaliser la source laser 7. Par exemple, le guide 200 est formée de l'empilement suivant en allant du bas vers le haut :
- une sous-couche inférieure en GaAs dopée N,
- des sous-couches à boites quantiques en AlGaAs, ou des puits quantiques AlGaAs, et
- une sous-couche supérieure en GaAs dopée P.

D'autres matériaux diélectriques sont possibles pour les matériaux 117 et 136 et la couche 20. Par exemple, il peut s'agir de nitrure de silicium, de nitrure d'Aluminium, d'un polymère électriquement isolant, de Al₂O₃.

En variante, une partie ou la totalité des prises de contact sont réalisées, non pas à travers le matériau 136, mais à travers le substrat 44. Dans ce cas, par rapport à ce qui a été représenté sur les figures précédentes, une ou plusieurs prises de contact électrique émergent sous le substrat 44.

Le substrat 44 peut être réalisé dans d'autre matériau que du silicium.

En variante, les guides 200, 220 sont incurvés. Dans ce cas, la conformation des différents éléments optiquement couplés à ces guides d'onde est adaptée au rayon de courbure de ces guides d'onde.

Ce qui a été décrit ici s'applique aussi au cas où le guide d'onde en silicium et le guide d'onde en matériau III-V ne sont pas des guides d'onde d'une source laser. Dans ce dernier cas, le guide d'onde en matériau III-V peut être réalisé dans un matériau III-V qui n'est pas nécessairement un matériau à gain.

### Chapitre IV - Avantages des modes de réalisation décrits :

A dimensions égales, l'inclusion 320 présente un indice effectif de propagation plus grand que l'indice effectif de propagation du silicium. Dès lors, les dimensions transversales de l'inclusion qui permettent d'obtenir un indice effectif de propagation égal à n_{eff306} sont bien plus petites que si seulement du silicium était utilisé. De plus, cette inclusion est réalisée dans un évidement du prolongement 308. Elle est donc enfoncée à l'intérieur de ce prolongement 308. Dans ces conditions, l'inclusion 320 permet d'atteindre un indice effectif de propagation égal à l'indice n_{eff306} sans que la hauteur de cette inclusion ne dépasse le plan P₂ₛᵤₚ. Ainsi, grâce à cette inclusion 320, il n'est pas nécessaire de réaliser, au niveau du prolongement 308, une surépaisseur en silicium pour obtenir un indice effectif de propagation égal à l'indice n_{eff306}. Dès lors, l'encombrement du coupleur optique 300 est réduit par rapport au cas où l'inclusion 320 ne serait pas utilisée.

Par ailleurs, l'inclusion 320 est réalisée dans un alliage SiGe dans lequel la concentration en germanium est comprise entre 20 % et 50 % atomiques, c'est-à-dire dans une plage de concentration où les pertes par absorption à l'intérieur de l'alliage SiGe sont faibles et pratiquement égales aux pertes par absorption d'un guide d'onde en silicium. Ainsi, l'inclusion 320 permet de réduire l'encombrement du coupleur optique sans augmenter de façon substantielle les pertes optiques.

Le fait de disposer l'inclusion 320 sur la semelle 324 en silicium permet de limiter le nombre de dislocations qui apparaissent lors de la fabrication de l'inclusion 320 et donc de limiter encore plus les pertes par absorption dans l'inclusion 320.

La terminaison 330 en pointe permet d'obtenir un couplage adiabatique entre l'inclusion 320 et le prolongement 306. Un tel couplage adiabatique est plus court que les autres couplages optiques possibles. Cela permet donc de réduire encore plus l'encombrement du coupleur optique 300. De plus, un tel couplage adiabatique permet d'obtenir une bande passante plus grande qu'avec d'autres technologies de couplage optique.

La terminaison 332 en pointe dont les flancs verticaux sont directement en appui sur les parois verticales de l'évidement 322 réalisées dans le prolongement 308, permet de coupler optiquement l'inclusion 320 au prolongement 308 tout en utilisant une inclusion 320 qui est entièrement située entre les plans P_{2inf} et P₂ₛᵤₚ. Cela permet donc de réduire encore plus l'encombrement du coupleur optique.

## Revendications

1. Puce photonique comportant :
- un substrat (44) qui s'étend principalement dans un plan appelé "plan du substrat",
- un premier guide d'onde (200) qui s'étend principalement parallèlement au plan du substrat et dont le coeur est en matériau III-V,
- un second guide d'onde (220) qui s'étend principalement parallèlement au plan du substrat et dont le coeur est en silicium,
- un coupleur optique (300) apte à transférer, entre le début et la fin d'une zone de couplage, au moins une partie d'un signal optique qui se propage, au début de la zone de couplage, dans l'un des premier et second guides d'onde vers l'autre des premier et second guides d'onde, ce coupleur optique comportant à cet effet :
- un premier prolongement (306) en matériau III-V qui prolonge le coeur du premier guide d'onde à l'intérieur de la zone de couplage,
- un second prolongement (308) en silicium qui prolonge le coeur du second guide d'onde à l'intérieur de la zone de couplage, ce second prolongement s'étendant en vis-à-vis du premier prolongement,
**caractérisé en ce que** le coupleur optique (300) comporte une inclusion (320) en SiGe enfoncée à l'intérieur du second prolongement (308), cette inclusion :
- étant réalisée en SiGe dont la formule chimique est Si₁₋ₓGeₓ, où x est compris entre 0,2 et 0,5, et
- étant optiquement couplée, d'un premier côté, au premier guide d'onde (200) et, d'un second côté opposé, au second guide d'onde (220).

2. Puce selon la revendication 1, dans laquelle l'inclusion est logée à l'intérieur d'un évidement (322) réalisé dans le second prolongement, le fond de cet évidement étant formé par une semelle (324) en silicium dont l'épaisseur est inférieure à l'épaisseur du second guide d'onde (220) et sur laquelle l'inclusion en SiGe est réalisée.

3. Puce selon l'une quelconque des revendications précédentes, dans laquelle :
- le premier guide d'onde et le premier prolongement sont entièrement situés entre des premiers plans inférieur (P_{1inf}) et supérieur (P₁ₛᵤₚ) parallèles au plan du substrat, le premier guide d'onde présentant des faces inférieure et supérieure contenues, respectivement, dans les premiers plans inférieur et supérieur,
- le second guide d'onde et le second prolongement sont entièrement situés entre des seconds plans inférieur (P_{2inf}) et supérieur (P₂ₛᵤₚ) parallèles au plan du substrat, le second guide d'onde présentant des faces inférieure et supérieure contenues, respectivement, dans les seconds plans inférieur et supérieur,
- les premiers et seconds plans inférieurs et supérieurs sont empilés les uns au-dessus des autres dans l'ordre suivant : le second plan inférieur (P_{2inf}), le second plan supérieur (P₂ₛᵤₚ), le premier plan inférieur (P_{1inf}) puis le premier plan supérieur (P₁ₛᵤₚ), et
- l'inclusion (320) est entièrement située entre les seconds plans inférieur et supérieur.

4. Puce selon la revendication 3, dans laquelle :
- du premier côté, l'inclusion (320) comporte une première terminaison (330) en pointe qui raccorde optiquement l'inclusion au premier guide d'onde, la largeur de cette première terminaison diminuant progressivement et continûment depuis une largeur maximale jusqu'à une largeur minimale en progressant en direction du premier guide d'onde, la largeur de la première terminaison étant mesurée dans une direction parallèle au plan du substrat et perpendiculaire à la direction de propagation du signal optique dans cette première terminaison,
- l'indice effectif de propagation de cette première terminaison (330) à l'emplacement où sa largeur est maximale est supérieur à l'indice effectif de propagation d'une portion du premier prolongement (306) située en vis-à-vis de cet emplacement de la première terminaison où sa largeur est maximale, et
- l'indice effectif de propagation de cette première terminaison (330) à l'emplacement où sa largeur est minimale est inférieur à l'indice effectif de propagation d'une portion du premier prolongement (306) située en vis-à-vis de cet emplacement de la première terminaison où sa largeur est minimale.

5. Puce selon l'une quelconque des revendications précédentes, dans laquelle :
- du second côté, l'inclusion comporte une seconde terminaison (332) en pointe qui raccorde optiquement l'inclusion au second guide d'onde (220), la largeur de cette seconde terminaison diminuant progressivement et continûment depuis une largeur maximale jusqu'à une largeur minimale en progressant en direction du second guide d'onde, des flancs verticaux de cette seconde terminaison étant directement en appui sur des parois verticales d'un évidement (322) creusé dans le second prolongement, ces flancs verticaux et ces parois verticales s'étendant chacun principalement dans un plan perpendiculaire au plan du substrat, la largeur de la seconde terminaison étant mesurée dans une direction parallèle au plan du substrat et perpendiculaire à la direction de propagation du signal optique dans cette seconde terminaison,
- l'indice effectif de propagation de cette seconde terminaison (332) à l'emplacement où sa largeur est maximale est supérieur à l'indice effectif de propagation du second guide d'onde (220), et
- l'indice effectif de propagation de cette seconde terminaison à l'emplacement où sa largeur est minimale est inférieur à l'indice effectif de propagation du second guide d'onde (220).

6. Puce selon l'une quelconque des revendications 3 à 5, dans laquelle la distance qui sépare le second plan inférieur (P_{2inf}) du second plan supérieur (P₂ₛᵤₚ) est inférieure ou égale à 310 nm.

7. Puce selon l'une quelconque des revendications précédentes, dans laquelle l'inclusion est réalisée en SiGe dont la formule chimique est Si₁₋ₓGeₓ, où x est compris entre 0,4 et 0,5.

8. Puce selon l'une quelconque des revendications précédentes, dans laquelle :
- le premier guide d'onde (200) est réalisé en matériau à gain III-V, et
- la puce comporte :
- une source laser (7) à semi-conducteur apte à générer le signal optique, cette source laser comportant le premier guide d'onde (200), le second guide d'onde (220) et le coupleur optique (300) qui raccorde optiquement les premier et second guides d'onde l'un à l'autre à travers une couche (20) en matériau diélectrique, et
- un modulateur (100) de phase et/ou d'amplitude réalisé sur le même substrat (44) et apte à moduler le signal optique généré par la source laser à semi-conducteur, ce modulateur comportant :
- une première électrode (120) en silicium dopée P ou N entièrement située entre les seconds plans inférieur (P_{2inf}) et supérieur (P₂ₛᵤₚ),
- une seconde électrode (130) présentant un dopage de signe opposé à celui de la première électrode.

9. Puce selon l'une quelconque des revendications précédentes, dans laquelle le second guide d'onde a un indice effectif de propagation inférieur à l'indice effectif de propagation du premier guide d'onde.

10. Procédé de fabrication d'une puce photonique conforme à l'une quelconque des revendications précédentes, dans lequel le procédé comporte :
- la fourniture (400) d'un substrat qui s'étend principalement dans un plan appelé "plan du substrat",
- la réalisation (452) d'un premier guide d'onde qui s'étend principalement parallèlement au plan du substrat et dont le coeur est en matériau III-V,
- la réalisation (402) d'un second guide d'onde qui s'étend principalement parallèlement au plan du substrat et dont le coeur est en silicium,
- la réalisation (414) d'un coupleur optique apte à transférer, entre le début et la fin d'une zone de couplage, au moins une partie d'un signal optique qui se propage, au début de la zone de couplage, dans l'un des premier et second guides d'onde vers l'autre des premier et second guides d'onde, ce coupleur optique comportant à cet effet :
- un premier prolongement en matériau III-V qui prolonge le coeur du premier guide d'onde à l'intérieur de la zone de couplage,
- un second prolongement en silicium qui prolonge le coeur du second guide d'onde à l'intérieur de la zone de couplage, ce second prolongement s'étendant en vis-à-vis du premier prolongement,
**caractérisé en ce que** la réalisation (414) du coupleur optique comporte la réalisation d'une inclusion en SiGe enfoncée à l'intérieur du second prolongement, cette inclusion :
- étant réalisée en SiGe dont la formule chimique est Si₁₋ₓGeₓ, où x est compris entre 0,2 et 0,5, et
- étant optiquement couplée, d'un premier côté, au premier guide d'onde et, d'un second côté opposé, au second guide d'onde.

11. Procédé selon la revendication 10, dans lequel la réalisation de l'inclusion en SiGe comporte une opération (440) de croissance par épitaxie de l'inclusion en SiGe sur une semelle en silicium.

## Patentansprüche

1. Photonischer Chip, umfassend:
- ein Substrat (44), das sich hauptsächlich in einer "Ebene des Substrats" genannten Ebene erstreckt,
- einen ersten Wellenleiter (200), der sich hauptsächlich parallel zur Ebene des Substrats erstreckt und dessen Kern aus III-V-Material besteht,
- einen zweiten Wellenleiter (220), der sich hauptsächlich parallel zur Ebene des Substrats erstreckt und dessen Kern aus Silizium besteht,
- einen Optokoppler (300), der geeignet ist, zwischen dem Anfang und dem Ende eines Kopplungsbereichs wenigstens einen Teil eines optischen Signals zu übertragen, das sich am Anfang des Kopplungsbereichs in einem von dem ersten und dem zweiten Wellenleiter zum anderen von dem ersten und dem zweiten Wellenleiter ausbreitet, wobei dieser Optokoppler zu diesem Zweck umfasst:
- eine erste Verlängerung (306) aus III-V-Material, die den Kern des ersten Wellenleiters in den Kopplungsbereich hinein verlängert,
- eine zweite Verlängerung (308) aus Silizium, die den Kern des zweiten Wellenleiters in den Kopplungsbereich hinein verlängert, wobei sich diese zweite Verlängerung gegenüber der ersten Verlängerung erstreckt,
**dadurch gekennzeichnet, dass** der Optokoppler (300) einen Einschluss (320) aus SiGe umfasst, der ins Innere der zweiten Verlängerung (308) eingearbeitet ist, wobei dieser Einschluss:
- aus SiGe hergestellt ist, dessen chemische Formel Si₁₋ₓGeₓ lautet, wobei x zwischen 0,2 und 0,5 liegt, und
- auf einer ersten Seite mit dem ersten Wellenleiter (200) und auf einer gegenüberliegenden zweiten Seite mit dem zweiten Wellenleiter (220) optisch gekoppelt ist.

2. Chip nach Anspruch 1, wobei der Einschluss im Inneren einer Vertiefung (322) aufgenommen ist, die in der zweiten Verlängerung ausgebildet ist, wobei der Boden dieser Vertiefung von einer Sohle (324) aus Silizium gebildet wird, deren Dicke kleiner als die Dicke des zweiten Wellenleiters (220) ist und auf welcher der Einschluss aus SiGe hergestellt ist.

3. Chip nach einem der vorhergehenden Ansprüche, wobei:
- der erste Wellenleiter und die erste Verlängerung sich vollständig zwischen einer unteren (P_{1inf}) und einer oberen (P₁ₛᵤₚ) ersten Ebene befinden, die zur Ebene des Substrats parallel sind, wobei der erste Wellenleiter eine untere und eine obere Fläche aufweist, die in der unteren bzw. oberen ersten Ebene enthalten sind,
- der zweite Wellenleiter und die zweite Verlängerung sich vollständig zwischen einer unteren (P_{2inf}) und einer oberen (P₂ₛᵤₚ) zweiten Ebene befinden, die zur Ebene des Substrats parallel sind, wobei der zweite Wellenleiter eine untere und eine obere Fläche aufweist, die in der unteren bzw. oberen zweiten Ebene enthalten sind,
- die unteren und oberen ersten und zweiten Ebenen in der folgenden Reihenfolge übereinandergestapelt sind: untere zweite Ebene (P_{2inf}), obere zweite Ebene (P₂ₛᵤₚ), untere erste Ebene (P_{1inf}), danach obere erste Ebene (P₁ₛᵤₚ), und
- der Einschluss (320) sich vollständig zwischen der unteren und der oberen zweiten Ebene befindet.

4. Chip nach Anspruch 3, wobei:
- auf der ersten Seite der Einschluss (320) ein sich zuspitzendes erstes Ende (330) umfasst, das den Einschluss mit dem ersten Wellenleiter optisch verbindet, wobei sich die Breite dieses ersten Endes in Richtung des ersten Wellenleiters allmählich und kontinuierlich von einer maximalen Breite bis zu einer minimalen Breite verringert, wobei die Breite des ersten Endes in einer Richtung gemessen wird, die zur Ebene des Substrats parallel und zur Ausbreitungsrichtung des optischen Signals in diesem ersten Ende senkrecht ist,
- der effektive Ausbreitungsindex dieses ersten Endes (330) an der Stelle, wo seine Breite maximal ist, größer als der effektive Ausbreitungsindex eines Abschnitts der ersten Verlängerung (306) ist, der sich gegenüber dieser Stelle des ersten Endes, wo seine Breite maximal ist, befindet, und
- der effektive Ausbreitungsindex dieses ersten Endes (330) an der Stelle, wo seine Breite minimal ist, kleiner als der effektive Ausbreitungsindex eines Abschnitts der ersten Verlängerung (306) ist, der sich gegenüber dieser Stelle des ersten Endes, wo seine Breite minimal ist, befindet.

5. Chip nach einem der vorhergehenden Ansprüche, wobei:
- auf der zweiten Seite der Einschluss ein sich zuspitzendes zweites Ende (332) umfasst, das den Einschluss mit dem zweiten Wellenleiter (220) optisch verbindet, wobei sich die Breite dieses zweiten Endes in Richtung des zweiten Wellenleiters allmählich und kontinuierlich von einer maximalen Breite bis zu einer minimalen Breite verringert, wobei vertikale Flanken dieses zweiten Endes direkt an vertikalen Wänden einer in der zweiten Verlängerung ausgebildeten Vertiefung (322) anliegen, wobei sich diese vertikalen Flanken und diese vertikalen Wände jeweils hauptsächlich in einer zur Ebene des Substrats senkrechten Ebene erstrecken, wobei die Breite des zweiten Endes in einer Richtung gemessen wird, die zur Ebene des Substrats parallel und zur Ausbreitungsrichtung des optischen Signals in diesem zweiten Ende senkrecht ist,
- der effektive Ausbreitungsindex dieses zweiten Endes (332) an der Stelle, wo seine Breite maximal ist, größer als der effektive Ausbreitungsindex des zweiten Wellenleiters (220) ist, und
- der effektive Ausbreitungsindex dieses zweiten Endes an der Stelle, wo seine Breite minimal ist, kleiner als der effektive Ausbreitungsindex des zweiten Wellenleiters (220) ist.

6. Chip nach einem der Ansprüche 3 bis 5, wobei der Abstand, der die untere zweite Ebene (P_{2inf}) von der oberen zweiten Ebene (P₂ₛᵤₚ) trennt, kleiner oder gleich 310 nm ist.

7. Chip nach einem der vorhergehenden Ansprüche, wobei der Einschluss aus SiGe hergestellt ist, dessen chemische Formel Si₁₋ₓGeₓ lautet, wobei x zwischen 0,4 und 0,5 liegt.

8. Chip nach einem der vorhergehenden Ansprüche, wobei:
- der erste Wellenleiter (200) aus III-V-Verstärkungsmaterial hergestellt ist, und
- der Chip umfasst:
- eine Halbleiterlaserquelle (7), die geeignet ist, das optische Signal zu erzeugen, wobei diese Laserquelle den ersten Wellenleiter (200), den zweiten Wellenleiter (220) und den Optokoppler (300), der den ersten und den zweiten Wellenleiter über eine Schicht (20) aus dielektrischem Material optisch miteinander verbindet, umfasst, und
- einen Phasen- und/oder Amplitudenmodulator (100), der auf demselben Substrat (44) hergestellt ist und geeignet ist, das von der Halbleiterlaserquelle erzeugte optische Signal zu modulieren, wobei dieser Modulator umfasst:
- eine erste Elektrode (120) aus p- oder n-dotiertem Silizium, die sich vollständig zwischen der unteren (P_{2inf}) und der oberen (P₂ₛᵤₚ) zweiten Ebene befindet,
- eine zweite Elektrode (130), die eine Dotierung mit einem Vorzeichen aufweist, das zu demjenigen der ersten Elektrode entgegengesetzt ist.

9. Chip nach einem der vorhergehenden Ansprüche, wobei der zweite Wellenleiter einen effektiven Ausbreitungsindex aufweist, der kleiner als der effektive Ausbreitungsindex des ersten Wellenleiters ist.

10. Verfahren zur Herstellung eines photonischen Chips gemäß einem der vorhergehenden Ansprüche, wobei das Verfahren umfasst:
- die Bereitstellung (400) eines Substrats, das sich hauptsächlich in einer "Ebene des Substrats" genannten Ebene erstreckt,
- die Herstellung (452) eines ersten Wellenleiters, der sich hauptsächlich parallel zur Ebene des Substrats erstreckt und dessen Kern aus III-V-Material besteht,
- die Herstellung (402) eines zweiten Wellenleiters, der sich hauptsächlich parallel zur Ebene des Substrats erstreckt und dessen Kern aus Silizium besteht,
- die Herstellung (414) eines Optokopplers, der geeignet ist, zwischen dem Anfang und dem Ende eines Kopplungsbereichs wenigstens einen Teil eines optischen Signals zu übertragen, das sich am Anfang des Kopplungsbereichs in einem von dem ersten und dem zweiten Wellenleiter zum anderen von dem ersten und dem zweiten Wellenleiter ausbreitet, wobei dieser Optokoppler zu diesem Zweck umfasst:
- eine erste Verlängerung aus III-V-Material, die den Kern des ersten Wellenleiters in den Kopplungsbereich hinein verlängert,
- eine zweite Verlängerung aus Silizium, die den Kern des zweiten Wellenleiters in den Kopplungsbereich hinein verlängert, wobei sich diese zweite Verlängerung gegenüber der ersten Verlängerung erstreckt,
**dadurch gekennzeichnet, dass** die Herstellung (414) des Optokopplers die Herstellung eines Einschlusses aus SiGe umfasst, der ins Innere der zweiten Verlängerung eingearbeitet ist, wobei dieser Einschluss:
- aus SiGe hergestellt ist, dessen chemische Formel Si₁₋ₓGeₓ lautet, wobei x zwischen 0,2 und 0,5 liegt, und
- auf einer ersten Seite mit dem ersten Wellenleiter und auf einer gegenüberliegenden zweiten Seite mit dem zweiten Wellenleiter optisch gekoppelt ist.

11. Verfahren nach Anspruch 10, wobei die Herstellung des Einschlusses aus SiGe einen Arbeitsvorgang (440) des Aufwachsens des Einschlusses aus SiGe durch Epitaxie auf einer Sohle aus Silizium umfasst.

## Claims

1. Photonic chip comprising:
- a substrate (44) that mainly extends in a plane called the "substrate plane",
- a first waveguide (200) that mainly extends parallel to the substrate plane and the core of which is made of III-V material,
- a second waveguide (220) that mainly extends parallel to the substrate plane and the core of which is made of silicon,
- an optical coupler (300) able to transfer, between the start and end of a coupling region, at least some of an optical signal propagating, at the start of the coupling region, through one of the first and second waveguides to the other of the first and second waveguides, this optical coupler comprising to this end:
- a first extension (306) made of III-V material that extends the core of the first waveguide into the coupling region,
- a second extension (308) made of silicon that extends the core of the second waveguide into the coupling region, this second extension lying facing the first extension,
**characterized in that** the optical coupler (300) comprises an SiGe inclusion (320) embedded in the second extension (308), this inclusion:
- being made of SiGe the chemical formula of which is Si₁₋ₓGeₓ, where x is comprised between 0.2 and 0.5, and
- being optically coupled, on a first side, to the first waveguide (200) and, on an opposite second side, to the second waveguide (220).

2. Chip according to Claim 1, wherein the inclusion is housed in a recess (322) produced in the second extension, the bottom of this recess being formed by a silicon base (324) the thickness of which is less than the thickness of the second waveguide (220) and on which the SiGe inclusion is produced.

3. Chip according to either one of the preceding claims, wherein:
- the first waveguide and the first extension are entirely located between first lower and upper planes (P_{1inf}, P₁ₛᵤₚ) parallel to the substrate plane, the first waveguide having lower and upper faces contained in the first lower and upper planes, respectively,
- the second waveguide and the second extension are entirely located between second lower and upper planes (P_{2inf}, P₂ₛᵤₚ) parallel to the substrate plane, the second waveguide having lower and upper faces contained in the second lower and upper planes, respectively,
- the first and second lower and upper planes are stacked on top of one another in the following order: the second lower plane (P_{2inf}), the second upper plane (P₂ₛᵤₚ), the first lower plane (P_{1inf}) then the first upper plane (P₁ₛᵤₚ), and
- the inclusion (320) is entirely located between the second lower and upper planes.

4. Chip according to Claim 3, wherein:
- on the first side, the inclusion (320) comprises a first tapered termination (330) optically connecting the inclusion to the first waveguide, the width of this first termination gradually and continuously decreasing from a maximum width to a minimum width as it approaches the first waveguide, the width of the first termination being measured in a direction parallel to the substrate plane and perpendicular to the direction of propagation of the optical signal in this first termination,
- the effective propagation index of this first termination (330) in the location where its width is maximum is greater than the effective propagation index of a segment of the first extension (306) situated facing this location of the first termination where its width is maximum, and
- the effective propagation index of this first termination (330) in the location where its width is minimum is less than the effective propagation index of a segment of the first extension (306) situated facing this location of the first termination where its width is minimum.

5. Chip according to any one of the preceding claims, wherein:
- on the second side, the inclusion comprises a second tapered termination (332) optically connecting the inclusion to the second waveguide (220), the width of this second termination gradually and continuously decreasing from a maximum width to a minimum width as it approaches the second waveguide, vertical flanks of this second termination being directly in abutment with vertical walls of a recess (322) hollowed out in the second extension, these vertical flanks and these vertical walls each extending mainly in a plane perpendicular to the substrate plane, the width of the second termination being measured in a direction parallel to the substrate plane and perpendicular to the direction of propagation of the optical signal in this second termination,
- the effective propagation index of this second termination (332) in the location where its width is maximum is greater than the effective propagation index of the second waveguide (220), and
- the effective propagation index of this second termination in the location where its width is minimum is less than the effective propagation index of the second waveguide (220).

6. Chip according to any one of Claims 3 to 5, wherein the distance separating the second lower plane (P_{2inf}) from the second upper plane (P₂ₛᵤₚ) is less than or equal to 310 nm.

7. Chip according to any one of the preceding claims, wherein the inclusion is made of SiGe the chemical formula of which is Si₁₋ₓGeₓ, where x is comprised between 0.4 and 0.5.

8. Chip according to any one of the preceding claims, wherein:
- the first waveguide (200) is made of a III-V gain material, and
- the chip comprises:
- a semiconductor laser source (7) able to generate the optical signal, this laser source comprising the first waveguide (200), the second waveguide (220) and the optical coupler (300) optically connecting the first and second waveguides to each other through a layer (20) made of dielectric material, and
- a phase and/or amplitude modulator (100) produced on the same substrate (44) and able to modulate the optical signal generated by the semiconductor laser source, this modulator comprising:
- a first electrode (120) made of p- or n-doped silicon entirely located between the second lower and upper planes (P_{2inf}, P₂ₛᵤₚ),
- a second electrode (130) doped the opposite type to the first electrode.

9. Chip according to any one of the preceding claims, wherein the second waveguide has an effective propagation index less than the effective propagation index of the first waveguide.

10. Process for fabricating a photonic chip according to any one of the preceding claims, wherein the process comprises:
- providing (400) a substrate that mainly extends in a plane called the "substrate plane",
- producing (452) a first waveguide that mainly extends parallel to the substrate plane and the core of which is made of III-V material,
- producing (402) a second waveguide that mainly extends parallel to the substrate plane and the core of which is made of silicon,
- producing (414) an optical coupler able to transfer, between the start and end of a coupling region, at least some of an optical signal propagating, at the start of the coupling region, through one of the first and second waveguides to the other of the first and second waveguides, this optical coupler comprising to this end:
- a first extension made of III-V material that extends the core of the first waveguide into the coupling region,
- a second extension made of silicon that extends the core of the second waveguide into the coupling region, this second extension lying facing the first extension, **characterized in that** producing (414) the optical coupler comprises producing an SiGe inclusion embedded in the second extension, this inclusion:
- being made of SiGe the chemical formula of which is Si₁₋ₓGeₓ, where x is comprised between 0.2 and 0.5, and
- being optically coupled, on a first side, to the first waveguide and, on an opposite second side, to the second waveguide.

11. Process according to Claim 10, wherein producing the SiGe inclusion comprises an operation (440) of epitaxially growing the SiGe inclusion on a silicon base.
